# EUROPEAN PATENT APPLICATION

(11) **EP 2 182 500 A1**
(43) Date of publication of application: **05.05.2010**
(21) Application number: 08105718.4
(22) Date of filing: 31.10.2008
(51) Int. Cl.: G08C 19/36, H02M 7/06, H03K 17/795

(54) **Digital inputs for electronic equipment**

(71) Applicant: Siemens AG, 80506 Munich (DE)
(72) Inventor: Kenney, Richard, Crewe, Cheshire CW1 5TY (GB)
(74) Representative: Morgan, Marc

(57) **Abstract**

A digital input for use with electronic equipment is provided in which an external common reference port and an external signal port are provided. A user is able to connect to these ports and a digital signal is generated be a rectifier and isolation coupler circuit connected to the ports which is dependent on the variation of the signal referenced to the common reference whether the variation is positive or negative. This enables a PNP or an NPN configuration to be made without the need to configure internal switches.

## Description

This invention relates to digital inputs for electronic equipment.

Digital inputs in equipment for industrial applications are classified as NPN (high side load) or PNP (low side load). In some cases it is advantageous to be able to use the same model of equipment for both NPN and PNP applications. Equipment designed for such situations provides an internal switch to enable the selection of PNP or NPN as appropriate.

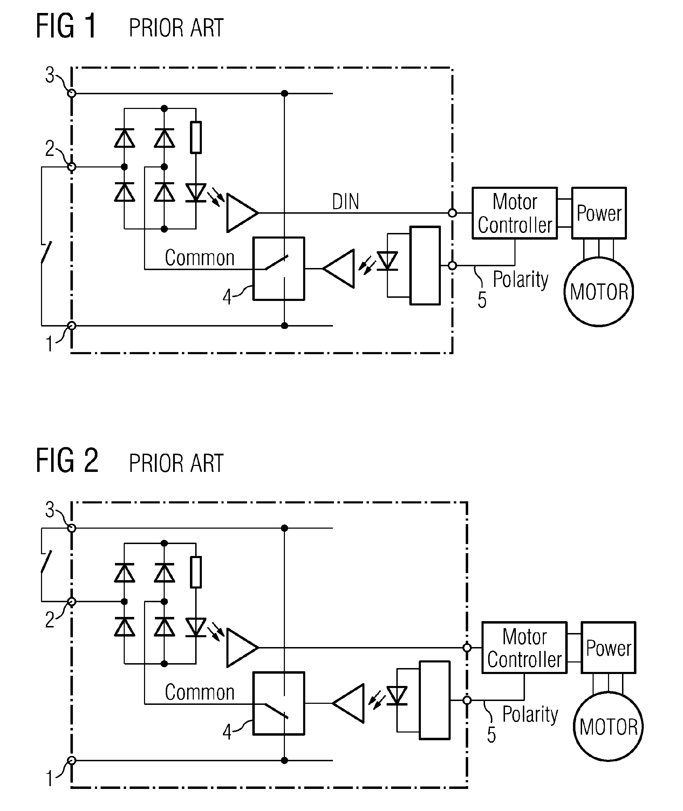

Figure 1 shows a prior art input arrangement in the context of providing inputs to equipment controlling an AC motor. The input circuit is provided with three input ports 1 to 3 to the exterior of the equipment casing. To configure the equipment, the user connects across the two external ports 1 and 2 and has to switch an internal switch 4 by means of a polarity control input 5. In figure 1 the switch is shown to for an NPN input. The same circuit may be used to provide a PNP input by changing the internal switch 4 and connecting the ports 2 and 3 as shown in prior art figure 2. As is shown, the polarity is selected by an input derived from the motor controller which requires the controller to be correctly configured by the user.

The present invention arose in an attempt to provide a more convenient way of allowing a digital input to be configured as PNP or NPN.

According to the invention there is provided a digital input for electronic equipment comprising two or more external ports at least one providing a common reference voltage level input and the other a signal input wherein the common reference input and the signal input are electrically isolated from power supplies or reference signals of the equipment, a rectifier circuit coupled to the common reference input and the signal input and providing an output coupled to an isolation coupler to be coupled, in use, to a digital input of another circuit.

Preferably, the isolation coupler is an opto-coupler although in alternative embodiments the coupling may be capacitive or inductive.

A specific embodiment of the invention will now be described by way of example only with reference to the drawings in which:
Figures 1 and 2 show prior art arrangements already described; and
Figure 3 shows a digital input in accordance with the invention.

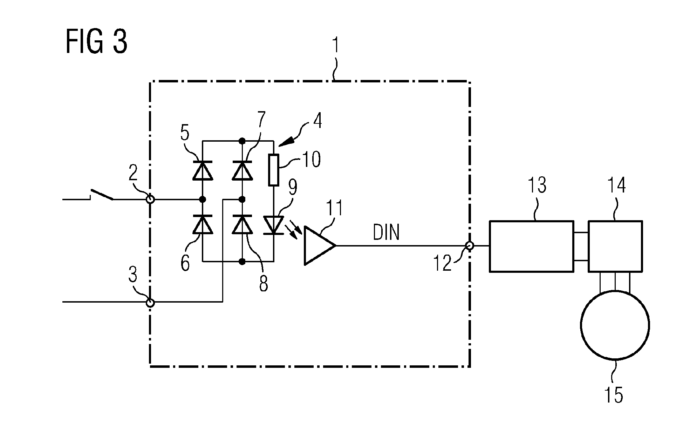

As is shown in figure 3, a digital input 1 for electronic equipment is shown. It comprises a pair of inputs ports 2 and 3 which are externally mounted and coupled internally to a rectifier circuit 4. Input port 2 is a signal input and input port 3 is a common reference input. The rectifier circuit 4 is, in this case, formed of a set of four diodes arranged as series pairs which are connected in parallel. It will be seen that the signal input port 2 is connected to the junction between diodes 5 and 6. The common reference port 3 is connected to a junction between the diodes 7 and 8.

The rectifier 4 is coupled across a light emitting diode 9 and a resistor 10 which are connected in series. The light emitting diode 9 is part of an isolation coupler in this case an opto-coupler which includes a detector 11. The detector 11 provides a signal to the Digital Input DIN 12 of a controller 13. The controller 13 is an example of electronic equipment which may utilise this digital input which in this case is used to control a power unit 14 for an AC motor 15. It will be appreciated that, whilst in this case, the digital input is shown as a separate unit to the controller 13 it may be integrated into that unit.

In use, a user connects an appropriate voltage reference to the common reference 3. A signal source is then connected to the input 2. As the signal varies relative to the common reference the resultant rectifier output drives the led 9 of the opto-coupler which is detected by the detector 11 and used as the basis for the signal applied to the digital input 12 to the controller 13.

Since the rectifier provides a signal based on the difference of the signal relative to the common reference voltage then a NPN or PNP configuration can be accommodated without the need to make internal adjustments of switches or the like as required in the prior art.

It will be seen from the figures that the digital input is not coupled to the power supplies or reference voltages of the equipment. The only connection is by mean of an isolation coupler 9, 11. This enhances the safe operating of the digital input.

If more than one digital input is required in a unit then the common reference connections may be connected together internally. Only N + 1 external connections are required for N digital inputs (one per digital input plus the common reference).

## Claims

1. A digital input for electronic equipment comprising two or more external ports at least one providing a common reference voltage level input and the other a signal input wherein the common reference input and the signal input are electrically isolated from power supplies or reference signals of the equipment, a rectifier circuit coupled to the common reference input and the signal input and providing an output coupled to an isolation coupler to be coupled, in use, to a digital input of another circuit.

2. A digital input as claimed in claim 1 wherein the isolation coupler is one of an inductive coupler, a capacitive coupler or an opto-coupler.

3. A digital input as claimed in claim 1 wherein more than one external port are coupled to provide the common reference input..

## Amended claims

### Amended claims in accordance with Rule 137(2) EPC.

**1.** A digital input (1) for electronic equipment(13-15) having a PNP or a NPN configuration comprising two or more external ports **characterised by** at least one providing a common reference voltage level input (3) and the other a DC signal input (2) wherein the common reference input and the DC signal input are electrically isolated from power supplies or reference signals of the equipment, a rectifier circuit (4) coupled to the common reference input and the DC signal input and providing an output coupled to an isolation coupler (9,11) to be coupled, in use, to a digital input (12) of electronic equipment (13-15) the common reference input adapted to be coupled to a respective appropriate reference voltage to enable matching to a PNP or NPN configuration respectively.

**2.** A digital input as claimed in claim 1 wherein the isolation coupler (9,11) is one of an inductive coupler, a capacitive coupler or an opto-coupler.

**3.** A digital input as claimed in claim 1 wherein more than one external port are coupled to provide the common reference input (3).

**4.** Apparatus comprising electronic equipment (13-15) having one of a PNP or NPN configuration and a digital input (1) as claimed in any preceding claim configured to match the one configuration of the electronic equipment.
